# EUROPEAN PATENT SPECIFICATION

(11) **EP 2 042 010 B1**
(45) Date of publication and mention of the grant of the patent: **16.09.2009**
(21) Application number: 06780580.4
(22) Date of filing: 28.06.2006
(51) Int. Cl.: H05K 7/20, B01D 46/42

(54) **FILTER-HOLDER CASE**
FILTERHALTER-GEHÄUSE
BOÎTIER PORTE-FILTRE

(43) Date of publication of application: 01.04.2009
(73) Proprietor: Gianus S.p.A., 20121 Milano (IT)
(72) Inventor: ZANGIROLAMI, Marco, I-28040 Borgoticino (IT)
(74) Representative: Garavelli, Paolo
(86) International application number: PCT/IT2006/000496
(87) International publication number: WO 2008/001396

(56) References cited:
- WO-A-02/32547
- DE-A1- 19 700 065
- DE-U1- 29 705 649
- US-A1- 6 030 427
- US-B1- 6 297 950

## Description

The present invention refers to an improved filter-holder case, particularly for electric cabinets or panels. DE-A1-197 00065 discloses a fitter-holder case according to the preamble of claim 1.

In many applications, above all in industrial environments, some electric components must be able to be protected from the contact with splashes of water, oil or chemical substances, corrosive or flammable gases, dusts, etc. It is therefore necessary that such components be contained in an electric cabinet or panel that has a protection grade equal to at least IP54 according to its specific standard, and that namely avoids the penetration of dust and liquids. This type of protection however has the inconvenience of preventing the disposal of heat that is generated inside the electric panel and it is therefore necessary to use a suitable venting system. In some applications, such as for example when electric components operate in non-hostile environments (due, for example, to the absence of dust, vapours, etc.), the venting system can be of the passive type and simply realised with suitable slits on the electric cabinet walls, which allow the direct exchange of hot air present inside the cabinet with colder air. This heat exchange can obviously occur spontaneously by exploiting the convective motions, since hot air tends to rise upwards; alternatively, the venting system can be of the active type and comprise suitable fans (for example of the axial or radial type) adapted to forcedly suck/expel air and to favour the heat exchange. However, when the electric cabinet or panel is in a dusty environment, it is necessary that the cooling air is filtered through protecting filters contained inside filter-holder cases inserted in suitable openings obtained on a wall, typically made of sheet, of the cabinet or panel itself. In particular, purpose of the filter-holder case is guaranteeing the water- and dust-tight closure, but the most air-permeable possible closure, of the opening in the cabinet wall in which it is installed, in order to guarantee a good venting of the equipment contained therein.

An efficient filter-holder case should therefore have the following qualities:
- easy fastening on cabinets with sheets with very different thickness (at least 1 to 4 mm);
- a discrete water-tightness degree which however does not limit the air passage;
- maximum easiness of replacement of the filter cloth when it is exhausted: the use of filters in fact requires a periodic maintenance, since their clogging generates a high air flow reduction, with a consequent temperature increase inside the cabinet.

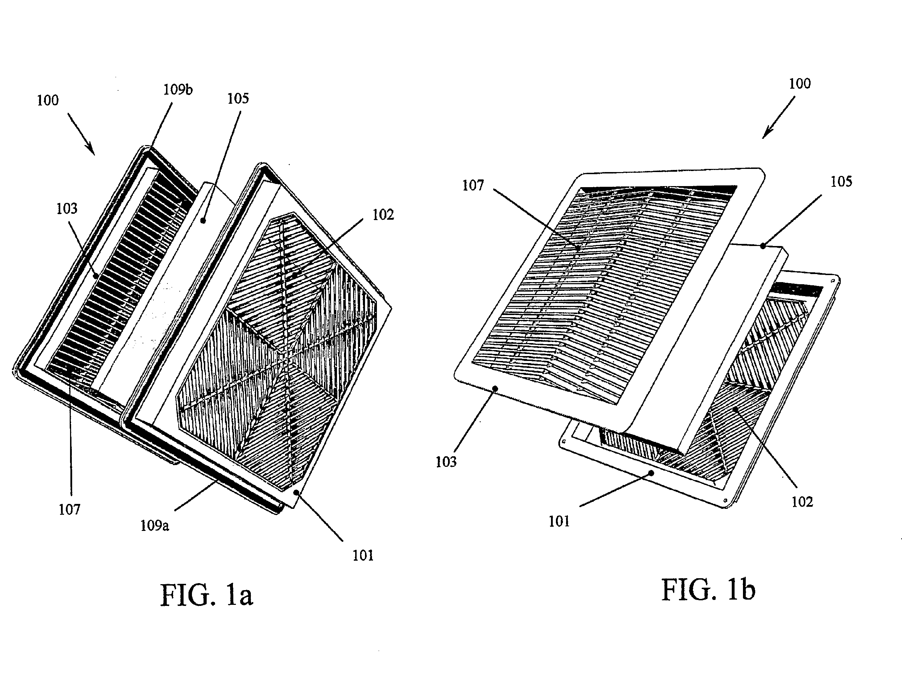

In general, as can be noted from enclosed FIG. 1a and 1b, existing filter-holder cases 100 are substantially composed of a base 101, a cover 103 and a filter cloth 105 contained and enclosed there between. The base 101 has only the mechanical purpose of being anchored inside an opening obtained in an electric cabinet wall, of providing the support for a possible fan associated therewith and of containing the filter cloth 105 in its thickness. In order to allow the passage of air, the base 101 is obviously equipped with a read grid 102. This type of existing base 101 however does not provide an adequate protection against the water passage, also because, for its installation (when it is even built by using through-screws which, by further drilling the cabinet wall, further impair the protection against the passage of liquids), a fastening system is provided, equipped with restraining tongues (not shown) which provide windows in various points in its external edge. Moreover, in existing bases 101, in the limit case in which the filter cloth 105 is completely impregnated, the rear grid 102 is not able to prevent water dripping inside the panel or cabinet. The cover 103, also characterised by an aesthetic function, is equipped with a front grid 107, typically of the imbricated type, whose purpose is allowing the air passage and limiting water penetration by dripping. However, during liquid projection (for example when performing IP55 tests), it has been detected how water can rise and impact onto the filter cloth 105, which is not the sole responsible for leading water from the base 101 feet preventing it from wetting the read grid 102 (not imbricated) and avoiding that this latter one is led on the flanks, from where, given the windows for realising the anchoring, it would enter without difficulty.

In a known filter-holder case 100, it is further necessary to have two sealing gaskets available, the first one 109a between base 101 and cabinet, the second one 109b between cover 103 and base 101, to prevent water, possibly penetrating from the edges, from entering into the cabinet through the fastening system windows. For such reason, the fastening system cannot be realised in the lower side of the base 101 of the filter-holder case 100, which often prevents, above all in filter-holder cases with bigger sizes, a correct coupling with the panel. Moreover, in addition to the described water tightness problem, the known fastening system has other further defects: in fact, it badly operates with a high range of cabinet wall thicknesses in which the filter-holder case (typically 1 - 2 millimetres of change are the maximum tolerable value) has to be installed. Moreover, it can be opened with difficulty when it is necessary to disassemble the filter-holder case itself.

A further problem of existing filter-holder cases 100 is given by the known difficulty of opening the cover 103 (for example, in case the filter cloth 105 has to be replaced or cleaned) since, in order to be able to improve the water tightness, it is deeply restrained in the base 101 and cannot be removed, apart from using a tool, such as for example a screw-driver, which, in addition to be scarcely practical, provides a fatal risk of damaging the gasket 109b of the cover 103, cancelling the original IP protection grade.

Therefore, object of the present invention is solving the above prior art problems by providing an improved filter-holder case equipped with a base and a moving grid, such moving grid cooperating with the base by interposing a hinged link, in such a way as to make its opening practical and quick, for example for enabling to replace the filter cloth contained inside it, without having to use a tool or excessive efforts.

Moreover, an object of the present invention is providing an improved filter-holder case equipped with a fastening system comprising at least one adjustable fastening jack in order to allow its installation inside an housing space obtained in electric cabinets or panels walls with a variable thickness in an extremely wide range.

Another object of the present invention is providing an improved filter-holder case equipped with a rear imbricated grid that is able to avoid dripping inside the electric cabinet or panel even in case the filter cloth is drenched with liquid.

A further object of the present invention is providing an improved filter-holder case that can be equipped with a single sealing gasket between base and electric cabinet or panel wall on which it is installed, though keeping its liquid tightness required by specific standards.

The above and other objects and advantages of the invention, as will result from the following description, are obtained with an improved filter-holder case as claimed in claim 1. Preferred embodiments and non-trivial variations of the present invention are the subject matter of the dependent claims.

The present invention will be better described by some preferred embodiments thereof, provided as a non-limiting example, with reference to the enclosed drawings, in which:
- FIG. 1a shows an exploded perspective view of a filter-holder case according to the prior art;
- FIG. 1b shows an exploded front perspective view of the filter-holder case of FIG. 1a;
- FIG. 2a shows a front perspective view of a preferred embodiment of the improved filter-holder case of the present invention in an open position;
- FIG. 2b shows another front perspective view of the improved filter-holder case according to the present invention in an open position;
- FIG. 2c shows a front perspective view of the improved filter-holder case of FIGG. 2a and 2b in a closed position;
- FIG. 3 shows a rear perspective view of the improved filter-holder case of the present invention in an open position;
- FIG. 4a shows an enlarged perspective view of a component of the fastening system of the improved filter-holder case according to the present invention pointed out by the dashed box A in FIG. 3;
- FIG. 4b shows another perspective view of the component of the fastening system of FIG. 4a; and
- FIG. 5a and 5b show enlarged front perspective views of some components of the fastening system.

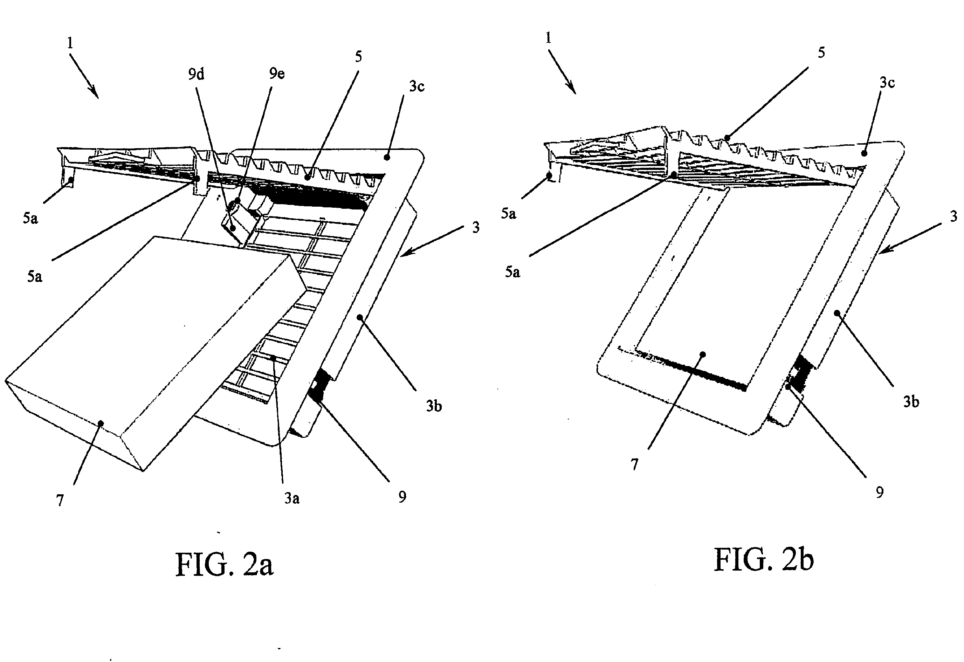

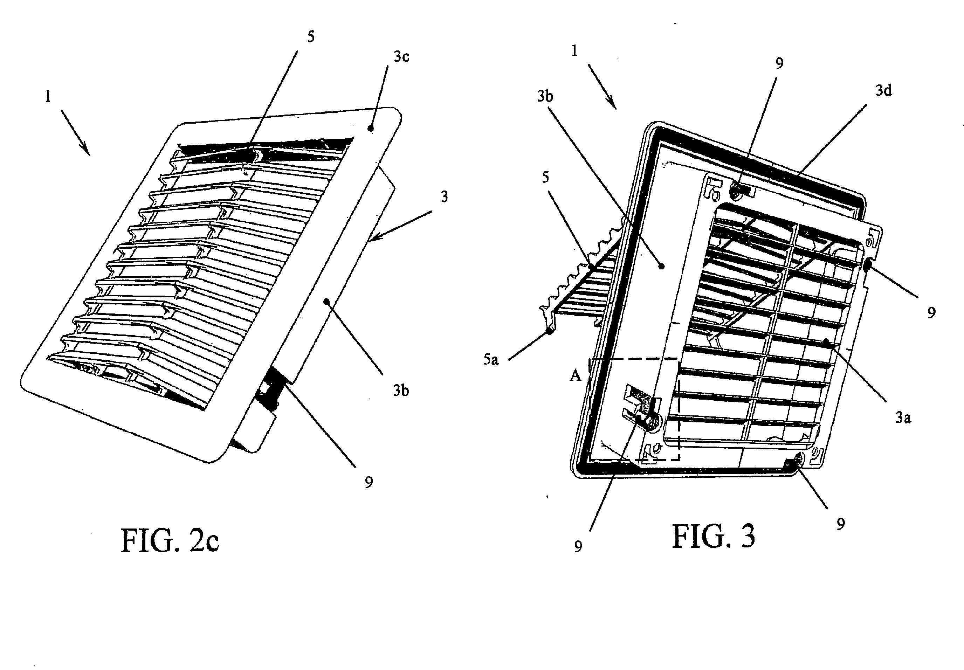

With reference to Figures 2a to 5b, it is possible to note that a preferred embodiment of the improved filter-holder case 1 according to the present invention comprises a main base 3, aimed to be secured inside a through-opening obtained in a wall of an electric cabinet or panel and at least one moving grid 5, such moving grid 5 cooperating with the main base 3 by interposing a hinged link. The hinged link allows the moving grid 5 to be taken, with respect to the main base 3 to which it is hinged, from an open position, as shown for example in FIG. 2a, 2b and 3, to a closed position, as shown for example in FIG. 2c. The main base 3 then comprises a rear grid 3a fitted, through side walls 3b, to a perimetral abutment frame 3c, this latter one being adapted to abut against the wall surface of the electric cabinet or panel in which the filter-holder case 1 according to the present invention is installed.

In particular, the moving grid 5, in its closed position, the rear grid 3a and the side walls 3b of the main base 3 define an internal space adapted to allow housing at least one filter cloth 7 overlapped with the rear grid 3a. The housing space of the main base 3 is obviously sized so that the filter cloth 7 is included between the rear grid 9 and the moving grid 5, when this latter one is in a closed position, such as for example the one shown in FIG. 2c, in order to filter the cooling air that is passively or actively flowing (such as for example when a downstream fan is associated with the filter-holder case 1) between moving grid 5 and rear grid 3a. When instead the moving grid 5 is taken in its open position, like the one for example shown in FIG. 2a and 2b, it is possible to easily access to the filter cloth 7 contained inside the housing space of the main base 3, to allow cleaning, removing or replacing the filter cloth 7.

In particular, the moving grid 5 is equipped with slits defined by imbricated tongues. Similarly, also the rear grid 3a can be equipped with slits defined by imbricated tongues in order to enable dripping inside the housing space and to prevent liquid from entering inside the electric cabinet or panel through the filter-holder case 1 even if the filter cloth 7 is drenched.

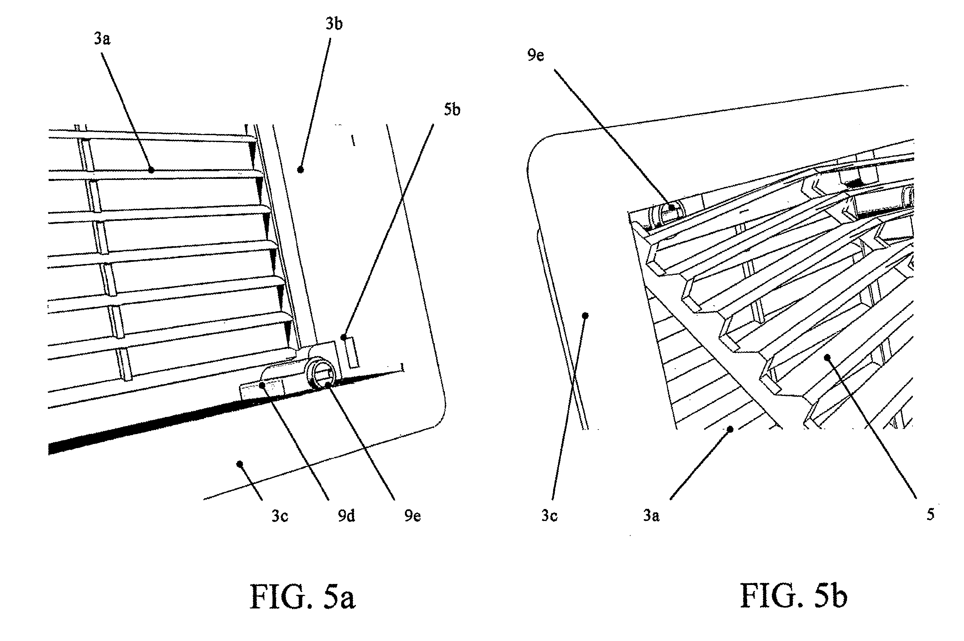

Obviously, the hinged link can be realised with an extremely wide range of solutions, easily devised by any skilled technician in the art. In particular, in a preferred embodiment thereof, also depending on production easiness and economy needs of the filter-holder case 1 according to the present invention, the hinged link is realised through two rotation pins (not shown) respectively arranged on the two opposite sides of the moving grid 5, preferably next to one end thereof, each one of which is housed in a corresponding seat respectively obtained on the internal surface to the housing space of two facing side walls 3c of the main base 3. In order to allow the reliable maintenance of its closed position, the moving grid 5 can be equipped with closing means, preferably made as at least one pair of closing tongues 5a each one of which is equipped with at least one closing tooth, adapted to elastically engage a respective closing seat 5b (like the one shown, for example, in FIG. 5a) obtained in the main base 3, when the moving grid 5 is in its closed position. In order to then proceed with opening the moving grid 5, it is enough to force the elasticity of the closing tongues 5a and disengage the closing teeth from their respective seats 5b. It is clear that elasticity and sizes of closing tongues 5a and related teeth can be sized in order to allow disengaging them from their respective closing seats 5b without requiring an excessive effort by an operator. In this way, the moving grid 5 can be easily opened without using any tool: it is therefore possible, for example, also for unskilled personnel, to easily and quickly proceed with the replacement of the filter cloth 7 contained inside the filter-holder case 1 of the invention. Obviously, it is possible to provide, should safety needs so require, that the moving grid 5 be equipped with a locking device in its closed position, which compels to use a tool for its opening.

In the filter-holder case 1 according to the present invention, as previously described, the perimetral abutment frame 3c of the main base 3 is visible and replacing the cover 103 frame of the filter-holder cases 100 according to the prior art and the moving grid 5, contrary to what instead occurs in existing filter-holder cases 100, it is not aimed to get in contact and/or to cooperate with any part of the electric cabinet or panel wall on which the case 1 is installed. In this way, in the filter-holder case 1 according to the present invention, it is possible to advantageously use a single sealing gasket 3d placed along the rear surface of the perimetral abutment frame 3c and adapted to be arranged between the perimetral abutment frame 3c and the wall surface of the electric cabinet or panel once having installed the filter-holder case 1 of the present invention, with a consequent and high saving of working and material with respect to prior art filter-holder cases 100, that allow using at least two different gaskets 109a and 109b as previously described.

Moreover, in the filter-holder case 1, the main base 3 integrates part of the material instead used by the cover 103 of filter-holder cases 100 according to the prior art, improving its stiffness (useful for a correct coupling with the cabinet and for supporting the possibly present fan). However, the economic balance is positive, since it can be demonstrated that the total of used material for building a filter-holder case 1 according to the present invention is globally less than the necessary one for producing a filter-holder case 100 of the prior art having similar sizes.

The filter-holder case 1 can obviously be installed in the respective opening obtained in a wall of an electric cabinet or panel using the prior art methods. Alternatively, the filter-holder case 1 according to the present invention can be equipped with a fastening system comprising at least one adjustable fastening jack 9 (the preferred embodiment of the filter-holder case 1 according to the present invention shown in the Figures is equipped as an example with a fastening system comprising four adjustable fastening jacks 9, each one arranged on the external surface of a different side wall 3b of the main base 3).

Each adjustable fastening jack 9, suitably housed in a seat 10 thereof obtained outside the side wall 3b of the main base 3, comprises an adjusting screw 9a and a fastening block 9b mutually cooperating to realise a screw-nut screw kinematism, the fastening block 9b being equipped with a fastening projection 9c.

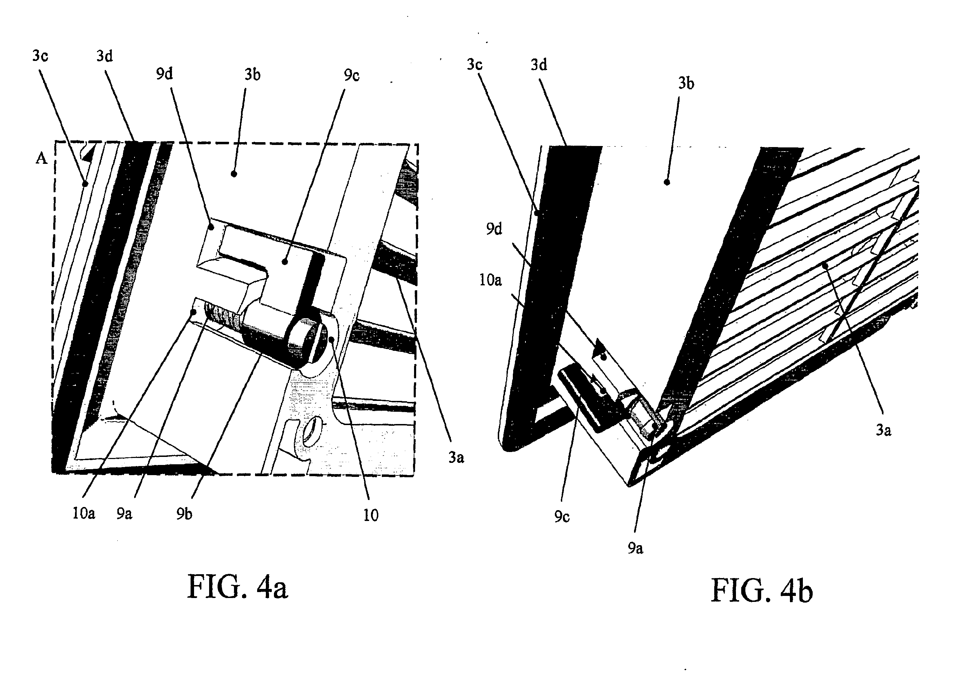

The fastening projection 9c is characterised by two main positions, a first one (as shown in FIG. 4a) in which it is housed inside an housing seat 9d thereof obtained outside the side wall 3b of the main seat 3 and a second one (as shown in FIG. 4b) in which it is outside its housing seat 9d and sliding along a longitudinal groove 10a of the seat 10 under the rotating action of the adjusting screw 9a on the fastening block 9b. In order to proceed with the installation of the filter-holder case 1 according to the present invention, therefore, when the fastening projection 9c is in its first position, it is possible to insert without interferences the main base 3 inside an opening thereof obtained in a wall of an electric panel or cabinet and suitably sized till the perimetral abutment frame 3c is in contact with the cabinet or panel wall. Afterwards, by rotating the adjusting screw 9a (for example clockwise in the preferred embodiment of the adjustable fastening jack 9 shown in the Figures), the fastening projection 9c is taken in its second position and going on rotating the adjusting screw 9a, the adjusting projection 9c, by sliding along the longitudinal groove 10a due to the effect of screw-nut screw coupling, is taken to press the wall thickness against the perimetral abutment frame 3c and the sealing gasket interposed there between: it is therefore enough to go on rotating the adjusting screw 9a till the pressure of the adjusting projection 9c guarantees an adequate adherence between perimetral abutment frame 3c and electric cabinet or panel wall. Obviously, to complete the fastening of the filter-holder case 1 inside its opening, it is enough to proceed as previously described with all other adjustable fastening jacks 9 with which the case 1 is equipped, or at least with a number of such jacks 9 deemed enough to guarantee a reliable installation and a correct coupling of the filter-holder case 1 according to the present invention on the electric panel or cabinet.

In order to make it easier to install the filter-holder case 1, as can be seen in particular from FIG. 5a and 5b, it is possible to arrange the seat 10 of the adjusting screw 9a so that its head 9e can advantageously be accessed, through for example a screw-driver or another suitable tool, frontally from the housing space of the filter cloth 7.

If the wall thickness of the electric panel or cabinet is particularly high, it is possible to shorten the fastening projection 9c by removing a part thereof, for example by using cutting nippers or another appropriate tool, in order to increase the wall thickness that the adjustable fastening jack 9 is able to press against the perimetral abutment frame 3c. In such a way, the fastening system realised through adjustable fastening jacks 9 allows, without creating accesses to liquids inside the electric cabinet or panel, easily assembling and disassembling the filter-holder case 1 according to the present invention for wall thicknesses ranging from 0 mm to 18 mm, this not being able to be proposed for filter-holder cases 100 according to the prior art.

Obviously, the fastening system of the filter-holder case 1 according to the present invention can be realised through other mechanisms able to be devised by any skilled person in the art, for example using a quick closing system with eccentric cam device (not shown).

Moreover, in the filter-holder case 1 according to the present invention, having parts of several components visible, such as main base 3 and moving grid 5, it is possible to employ the effect coupled with the colours of such components to obtain a new style image. The easy interchangeability of the moving grid 5 on the same main base 3 further allows customising the filter-holder case 1, economically and with a great differential impact. Moreover, since the moving grid 5 is quite smaller than an existing cover 103, the production of a filter-holder case 1 according to the present invention requires dies with smaller sizes, thereby resulting further inexpensive with respect to what is proposed by the prior art.

## Claims

1. Filter-holder case (1) comprising a main base (3) adapted to be fastened inside an opening of a wall; at least one moving grid (5), said moving grid (5) cooperating with said main base (3) by interposing a hinged link to be taken with respect to said main base (3) between an open position and a closed position; **characterised in that** it further comprises a fastening system in said opening of said wall, said fastening system comprising at least one adjustable fastening jack (9), said adjustable fastening jack (9) being housed in a seat (10) thereof outside a side wall (3b) of said main base (3) and comprising an adjusting screw (9a) and a fastening block (9b) mutually cooperating for realising a screw-nut screw kinematism, said fastening block (9b) being equipped with a fastening projection (9c).

2. Filter-holder case (1) according to claim 1, **characterised in that** said main base (3) comprises a rear grid (3a) fitted through side walls (3b) to a perimetral abutment frame (3c).

3. Filter-holder case (1) according to claim 1, **characterised in that** said moving grid (5) in said closed position, said rear grid (3a) and said side walls (3b) of said main base (3) define an internal housing space of at least one filter cloth (7).

4. Filter-holder case (1) according to claim 1, **characterised in that** said moving grid (5) is equipped with slits defined by imbricated tongues.

5. Filter-holder case (1) according to claim 1, **characterised in that** said rear grid (3a) is equipped with slits defined by imbricated tongues.

6. Filter-holder case (1) according to claim 1, **characterised in that** said hinged link is made of two rotation pins respectively arranged on two opposite sides of said moving grid (5), each one of which is housed in a corresponding seat respectively obtained on an internal surface to said housing space of said two facing side walls (3c) of the main base (3).

7. Filter-holder case (1) according to claim 1, **characterised in that** said moving grid (5) is equipped with closing means.

8. Filter-holder case (1) according to claim 7, **characterised in that** said closing means comprise at least one pair of closing tongues (5a) each one of which is equipped with at least one closing tooth adapted to elastically engage a respective closing seat (5b) obtained in said main base (3).

9. Filter-holder case (1) according to claim 1, **characterised in that** said moving grid (5) is equipped with a blocking device in its closed position for whose opening it is necessary to use a tool.

10. Filter-holder case (1) according to claim 1, **characterised in that** only a rear surface of said perimetral abutment frame (3c) is equipped with a sealing gasket (3d).

11. Filter-holder case (1) according to claim 1, **characterised in that** said fastening projection (9c) is taken from a first position in which it is housed inside a housing seat (9d) thereof obtained outside said side wall (3b) of said main seat (3) to a second position in which it is outside said housing seat (9d) and sliding along a longitudinal groove (10a) of said seat (10) under a rotation action of said adjusting screw (9a) on said fastening block (9b).

12. Filter-holder case (1) according to claim 1, **characterised in that** a length of said fastening projection (9c) is adapted to be reduced.

13. Filter-holder case (1) according to claim 1, **characterised in that** a head (9e) of said adjusting screw (9a) can be frontally accessed from said housing space of said filter cloth (7).

14. Filter-holder case (1) according to claim 1, **characterised in that** said fastening system comprises a quick closing system with eccentric cam device.

15. Use of said filter-holder case (1) according to claim 1 for filtering cooling air in electric cabinets or panels.

## Patentansprüche

1. Filtergehäuse (1) mit einer Hauptbasis (3), die dazu dient, in einer Wandöffnung befestigt zu werden; mindestens ein bewegliches Gitter (5), das genannte Gitter (5) arbeitet mit der genannten Hauptbasis (3) durch Dazwischenlegen eines Scharniergelenks zusammen, um gegenüber der genannten Hauptbasis (3) zwischen eine geöffnete und eine geschlossene Position geführt zu werden; außerdem ist das Filtergehäuse **dadurch gekennzeichnet, dass** es ein Befestigungssystem in der genannten Wandöffnung einschließt, das genannte Befestigungssystem schließt mindestens eine verstellbare Befestigungswinde (9) ein, die genannte verstellbare Befestigungswinde (9) ist in ihrer externen Aufnahme (10) an einer Seitenwand (3b) der genannten Hauptbasis (3) enthalten und schließt eine Stellschraube (9a) und einen Befestigungsblock (9b) ein, die zusammenarbeiten, um ein Schrauben-Schraubenmutter-Getriebe zu realisieren, der genannte Befestigungsblock (9b) ist mit einem Befestigungsbutzen (9c) ausgestattet.

2. Filtergehäuse (1) gemäß Patentanspruch 1, das **dadurch gekennzeichnet ist, dass** die genannte Hauptbasis (3) ein hinteres Gitter (3a) einschließt, das durch Seitenwände (3b) und einen Perimeter-Kontrastrahmen (3c) verbunden ist.

3. Filtergehäuse (1) gemäß Patentanspruch 1, das **dadurch gekennzeichnet ist, dass** das genannte bewegliche Gitter (5) in der genannten geschlossenen Position, das genannte hintere Gitter (3a) und die genannten Seitenwände (3b) der genannten Hauptbasis (3) ein internes Aufnahmefach von mindestens einer Filtermatte (7) abgrenzen.

4. Filtergehäuse (1) gemäß Patentanspruch 1, das **dadurch gekennzeichnet ist, dass** das genannte bewegliche Gitter (5) mit Schlitzen ausgestattet ist, die durch Schleifenrippen abgegrenzt werden.

5. Filtergehäuse (1) gemäß Patentanspruch 1, das **dadurch gekennzeichnet ist, dass** das genannte hintere Gitter (3a) mit Schlitzen ausgestattet ist, die durch Schleifenrippen abgegrenzt werden.

6. Filtergehäuse (1) gemäß Patentanspruch 1, das **dadurch gekennzeichnet ist, dass** das genannte Scharniergelenk durch zwei Drehzapfen realisiert ist, die entsprechend an zwei gegenüber liegenden Seiten des genannten beweglichen Gitters (5) angeordnet sind, jeder der Drehzapfen ist in einer entsprechenden Aufnahme an einer entsprechenden Innenfläche des genannten Aufnahmefaches der beiden genannten Seitenwände (3c), die auf die genannte Hauptbasis (3) ausgerichtet sind, enthalten.

7. Filtergehäuse (1) gemäß Patentanspruch 1, das **dadurch gekennzeichnet ist, dass** das genannte bewegliche Gitter (5) mit Schließvorrichtungen ausgestattet ist.

8. Filtergehäuse (1) gemäß Patentanspruch 7, das **dadurch gekennzeichnet ist, dass** die genannten Schließvorrichtungen mindestens ein Verschlussrippenpaar (5a) enthalten, das jeweils mit mindestens einem Verschlussstift ausgestattet ist, der dazu dient, eine entsprechende Verschlussaufnahme (5b) in der genannten Hauptbasis (3) elastisch zu spannen.

9. Filtergehäuse (1) gemäß Patentanspruch 1, das **dadurch gekennzeichnet ist, dass** das genannte bewegliche Gitter (5) in seiner Schließposition mit einer Blockiervorrichtung ausgestattet ist, für deren Öffnung die Verwendung eines Werkzeuges notwendig ist.

10. Filtergehäuse (1) gemäß Patentanspruch 1, das **dadurch gekennzeichnet ist, dass** nur eine hintere Fläche des genannten Perimeter-Kontrastrahmens (3c) mit einer Dichtung (3d) ausgestattet ist.

11. Filtergehäuse (1) gemäß Patentanspruch 1, das **dadurch gekennzeichnet ist, dass** der genannte Befestigungsbutzen (9c) aus einer ersten Position, in der dieser in seiner Aufnahme (9d), die extern an der genannten Seitenwand (3b) der genannten Hauptbasis (3) erhalten wurde, enthalten ist, auf eine zweite Position geführt wird, in der sich dieser außerhalb der genannten Aufnahme (9d) befindet und unter der Einwirkung einer Drehung der genannten Stellschraube (9a) am genannten Befestigungsblock (9b) entlang einer Längsrille (10a) der genannten Aufnahme (10) verschoben wird.

12. Filtergehäuse (1) gemäß Patentanspruch 1, das **dadurch gekennzeichnet ist, dass** die Länge des genannten Befestigungsbutzens (9c) dazu dient, reduziert zu werden.

13. Filtergehäuse (1) gemäß Patentanspruch 1, das **dadurch gekennzeichnet ist, dass** ein Kopf (9e) der genannten Stellschraube (9a) von vorn durch das genannte Aufnahmefach der genannten Filtermatte (7) erreichbar ist.

14. Filtergehäuse (1) gemäß Patentanspruch 1, das **dadurch gekennzeichnet ist, dass** das genannte Befestigungssystem ein Schnellverschlusssystem mit einer Nockenvorrichtung einschließt.

15. Verwendung des genannten Filtergehäuses (1) gemäß Patentanspruch 1 für die Filtrierung der Kühlluft in Schränken oder Schaltschränken.

## Revendications

1. Coffret porte filtre (1) comprenant une base principale (3) pouvant être fixée à l'intérieur d'une ouverture pratiquée dans une paroi; au moins une grille mobile (5), ladite grille mobile (5) coopérant avec ladite base principale (3) au moyen de l'interposition d'une articulation à charnière pour être placée, par rapport à ladite base principale (3) entre une position ouverte et une position fermée; **caractérisé en ce qu'**il comprend en outre un système de fixation dans ladite ouverture de ladite paroi, ce système de fixation comprenant au moins un vérin réglable de fixation (9), ledit vérin réglable de fixation (9) étant niché dans un logement (10) extérieur à une paroi latérale (3b) de ladite base principale (3) et comprenant une vis de réglage (9a) et un bloc de fixation (9b) à coopération mutuelle pour réaliser la cinématique vis - vis mère, ledit bloc de fixation (9b) étant muni d'une protubérance de fixation (9c).

2. Coffret porte filtre (1) selon la revendication 1, **caractérisé en ce que** ladite base principale (3) comprend une grille arrière (3a) raccordée au moyen de parois latérales (3b) à une corniche de périmètre de contraste (3c).

3. Coffret porte filtre (1) selon la revendication 1, **caractérisé en ce que** ladite grille mobile (5) en position fermée, ladite grille arrière (3a) et lesdites parois latérales (3b) de ladite base principale (3) définissent un compartiment interne de logement d'au moins un tissu filtrant (7).

4. Coffret porte filtre (1) selon la revendication 1, **caractérisé en ce que** ladite grille mobile (5) est pourvue de fentes définies par des ailettes imbriquées.

5. Coffret porte filtre (1) selon la revendication 1**, caractérisé en ce que** ladite grille arrière (3a) est pourvue de fentes définies par des ailettes imbriquées.

6. Coffret porte filtre (1) selon la revendication 1, **caractérisé en ce que** ladite articulation à charnière est réalisée avec deux axes de rotation placés respectivement sur les deux côtés opposés de ladite grille mobile (5), chacun de ces deux axes étant logé dans un siège correspondant, pratiqué respectivement sur la surface interne audit logement du siège des deux parois latérales (3c) de la base principale (3).

7. Coffret porte filtre (1) selon la revendication 1, **caractérisé en ce que** ladite grille mobile (5) possède des moyens de fermeture.

8. Coffret porte filtre (1) selon la revendication 7, **caractérisé en ce que** lesdits moyens de fermeture comprennent au moins une paire d'ailettes de fermeture (5a) chacune desquelles étant pourvue d'au moins une dent de fermeture capable d'engager en mode élastique un logement de fermeture (5b) correspondant, pratiqué dans ladite base principale (3).

9. Coffret porte filtre (1) selon la revendication 1, **caractérisé en ce que** ladite grille mobile (5) est équipée d'un dispositif de blocage dans sa position fermée et pour l'ouverture de laquelle l'utilisation d'un outil s'avère nécessaire.

10. Coffret porte filtre (1) selon la revendication 1, **caractérisé en ce que** seule une surface arrière de ladite corniche de périmètre de contraste (3c) est pourvue d'un joint étanche (3d).

11. Coffret porte filtre (1) selon la revendication 1, **caractérisé en ce que** ladite protubérance de fixation (9c) est amenée d'une première position - dans laquelle elle est logée à l'intérieur de son logement (9d) pratiqué à l'extérieur de ladite paroi latérale (3b) dudit logement principal (3) - à une seconde position dans laquelle elle se trouve à l'extérieur dudit logement (9d) et coulissant le long d'une rainure longitudinale (10a) dudit logement (10) sous l'action d'une rotation de ladite vis de réglage (9a) sur ledit bloc de fixation (9b).

12. Coffret porte filtre (1) selon la revendication 1, **caractérisé en ce que** la longueur de ladite protubérance de fixation (9c) peut être réduite.

13. Coffret porte filtre (1) selon la revendication 1, **caractérisé en ce qu'**une tête (9e) de ladite vis de réglage (9a) est accessible de face à partir dudit compartiment de logement du tissu filtrant cité plus haut (7).

14. Coffret porte filtre (1) selon la revendication 1, **caractérisé en ce que** ledit système de fixation comprend un système de fermeture rapide avec dispositif à came excentrique.

15. Utilisation dudit coffret porte filtre (1) selon la revendication 1 pour le filtrage de l'air de refroidissement en armoires ou dans les tableaux électriques.
